# EUROPEAN PATENT APPLICATION

(11) **EP 4 539 644 A2**
(43) Date of publication of application: **16.04.2025**
(21) Application number: 24202287.9
(22) Date of filing: 24.09.2024
(51) Int. Cl.: H10K 59/122, H10K 59/35, H10K 59/80, H10K 50/844, H10K 50/858

(54) **DISPLAY DEVICE**

(30) Priority: 25.09.2023 KR 20230127645
(71) Applicant: Samsung Display Co., Ltd., Gyeonggi-do 17113 (KR)
(72) Inventor: KIM, Jung Su, Yongin-si (KR); KWACK, Jin Ho, Yongin-si (KR); KIM, Chang Mok, Yongin-si (KR)
(74) Representative: Marks & Clerk LLP

(57) **Abstract**

A display device includes a substrate on which a display area and a non-display area are defined, a first bank layer disposed on the substrate and defining openings in the display area, a second bank layer disposed on the first bank layer and including a side more protruded than a side of the first bank layer, light emitting elements disposed on the substrate and overlapping the openings, a first inorganic encapsulation layer disposed on the light emitting elements, an organic encapsulation layer disposed on the first inorganic encapsulation layer and the second bank layer, a second inorganic encapsulation layer disposed on the organic encapsulation layer; and a first dam disposed between the substrate and the second inorganic encapsulation layer in the non-display area, where an area of a first side of the first dam does not overlap the first inorganic encapsulation layer in a thickness direction of the substrate.

## Description

### BACKGROUND

### 1. Field

The disclosure relates to a display device.

### 2. Description of the Related Art

With the advancement of the information age, the demand for a display device for displaying an image has increased with various forms. The display device may be a flat panel display device such as a liquid crystal display device, a field emission display device or an organic light emitting display device. Among such flat panel display devices, the light emitting display device includes a light emitting element in which each of the pixels of a display panel may self-emit light, thereby displaying an image without using a backlight unit that provides the display panel with light.

The display device typically includes a display area that displays an image and a non-display area near the display area, for example, a non-display area disposed to surround the display area. Recently, in order to increase the immersion of the display area and increase an aesthetic appeal of the display device, a width of the non-display area has been gradually reduced.

### BRIEF SUMMARY

Embodiments of the disclosure provide a display device in which a width of a non-display area is narrow and anti-moisture permeation performance is improved.

According to an embodiment of the disclosure, a display device includes a substrate on which a display area and a non-display area disposed near the display area are defined; a first bank layer disposed on the substrate, where the first bank layer defines a plurality of openings in the display area; a second bank layer disposed on the first bank layer, where the second bank layer includes a side more protruded than a side of the first bank layer; a plurality of light emitting elements disposed on the substrate and overlapping the openings; a first inorganic encapsulation layer disposed on the light emitting elements; an organic encapsulation layer disposed on the first inorganic encapsulation layer and the second bank layer; a second inorganic encapsulation layer disposed on the organic encapsulation layer; and a first dam disposed between the substrate and the second inorganic encapsulation layer in the non-display area, where an area of a first side of the first dam does not overlap the first inorganic encapsulation layer in a thickness direction of the substrate.

In an embodiment, the first side of the first dam may be directed toward the display area, and the organic encapsulation layer may overlap the first side of the first dam in the thickness direction of the substrate.

In an embodiment, the first side of the first dam may be in contact with the organic encapsulation layer, and a second side of the first dam, which is opposite to the first side thereof, may be in contact with the second inorganic encapsulation layer.

In an embodiment, the first inorganic encapsulation layer may include a first inorganic layer disposed on the light emitting elements and a second inorganic layer disposed on the first dam and spaced apart from the first inorganic layer.

In an embodiment, the first inorganic layer may include a plurality of sub-inorganic layers disposed on each of the light emitting elements, and the sub-inorganic layers of the first inorganic layer may be spaced apart from each other.

In an embodiment, the second inorganic layer may include the same material as a material of a corresponding one of the sub-inorganic layers of the first inorganic layer.

In an embodiment, the second inorganic layer may include a plurality of sub-inorganic layers sequentially stacked on the first dam.

In an embodiment, the display device may further include a second dam between the first dam and the light emitting elements.

In an embodiment, the second inorganic layer may include a first sub-inorganic layer disposed on the first dam and a second sub-inorganic layer disposed on the second dam, and the first sub-inorganic layer and the second sub-inorganic layer may be spaced apart from each other.

In an embodiment, the second inorganic layer may further include a third sub-inorganic layer disposed on the first sub-inorganic layer.

In an embodiment, each of the light emitting elements may include a pixel electrode disposed on the substrate and overlapping the openings; a light emitting layer disposed on the pixel electrode; and a common electrode disposed on the light emitting layer, and one end of the common electrode and another end of the common electrode, which is opposite to the one end thereof, overlap the openings.

In an embodiment, the common electrode may be in contact with the first bank layer.

In an embodiment, the first inorganic encapsulation layer may include a plurality of sub-inorganic layers disposed on the light emitting element overlapped with the openings and the second bank layer near the openings.

In an embodiment, the display device may further include a third inorganic encapsulation layer disposed between the first inorganic encapsulation layer and the organic encapsulation layer.

According to an embodiment of the disclosure, a display device includes a substrate on which a display area and a non-display area disposed near the display area are defined; a first bank layer disposed on the substrate, where the first bank layer defines a plurality of openings in the display area; a second bank layer disposed on the first bank layer, where the second bank layer includes a side more protruded than a side of the first bank layer; a first light emitting element disposed on the substrate and overlapping a first opening of the openings; a second light emitting element disposed on the substrate and overlapping a second opening spaced apart from the first opening; a first dam disposed on the substrate in the non-display area; a first inorganic encapsulation layer including a first sub-inorganic layer disposed on the first light emitting element, a second sub-inorganic layer disposed on the second light emitting element and a third sub-inorganic layer disposed on the first dam; an organic encapsulation layer disposed on the first inorganic encapsulation layer; and a second inorganic encapsulation layer disposed on the organic encapsulation layer, where the first sub-inorganic layer, the second sub-inorganic layer and the third sub-inorganic layer of the first inorganic encapsulation layer may be spaced apart from one another.

In an embodiment, the first sub-inorganic layer and the second sub-inorganic layer may be in contact with a lower surface of the second bank layer.

In an embodiment, a first side of the first dam may be in contact with the organic encapsulation layer, and a second side of the first dam, which is opposite to the first side thereof, may be in contact with the second inorganic encapsulation layer.

According to an embodiment of the disclosure, a display device includes a substrate on which a display area and a non-display area disposed near the display area are defined; a plurality of light emitting elements disposed on the substrate in the display area; a first dam disposed on the substrate in the non-display area; a second dam disposed on the substrate in the non-display area and positioned between the light emitting elements and the first dam; a first inorganic encapsulation layer including a first sub-inorganic layer disposed on the first dam, a second sub-inorganic layer disposed on the first sub-inorganic layer and a third sub-inorganic layer disposed on the second dam; an organic encapsulation layer disposed on the light emitting elements and the third sub-inorganic layer; and a second inorganic encapsulation layer disposed on the organic encapsulation layer and the first dam, wherein the first sub-inorganic layer and the third sub-inorganic layer may be spaced apart from each other.

In an embodiment, the first inorganic encapsulation layer may include a fourth sub-inorganic layer disposed on a first light emitting element of the light emitting elements, and a fifth sub-inorganic layer disposed on a second light emitting element and spaced apart from the fourth sub-inorganic layer, the first sub-inorganic layer may include a same material as a material of the fourth sub-inorganic layer, and the second sub-inorganic layer may include a same material as a material of the fifth sub-inorganic layer.

In an embodiment, a first side of the first dam may overlap the organic encapsulation layer, a second side of the first dam, which is opposite to the first side thereof, may not overlap the organic encapsulation layer, and a first side of the second dam and a second side of the second dam, which is opposite to the first side thereof, may overlap the organic encapsulation layer.

At least some of the above and other features of the invention are set out in the claims.

The display device according to embodiments may have improved anti-moisture permeation performance.

The display device according to embodiments may have a non-display area having a narrow width.

The effects according to the embodiments of the disclosure are not limited to those mentioned above and more various effects are included in the following description of the disclosure.

### BRIEF DESCRIPTION OF THE DRAWINGS

The above and other features of embodiments of the disclosure will become more apparent by describing in detail embodiments thereof with reference to the accompanying drawings, in which:
FIG. 1 is a perspective view illustrating a display device according to an embodiment;
FIG. 2 is a plan view illustrating the display device of FIG. 1 in a folded state when viewed on a front surface;
FIG. 3 is a cross-sectional view illustrating the display device of FIG. 1 in a folded state folded when viewed on a side;
FIG. 4 is a plan view illustrating a display layer of a display device according to an embodiment;
FIG. 5 is a plan view illustrating the arrangement of a light emission area and a second bank layer in a display area of a display device according to an embodiment;
FIG. 6 is a cross-sectional view illustrating a display area of a display device according to an embodiment;
FIG. 7 is an enlarged plan view illustrating a first light emission area of FIG. 6;
FIGS. 8 to 10 are enlarged cross-sectional views illustrating a first light emission area of a display device according to other embodiments;
FIG. 11 is an enlarged plan view illustrating an area A2 of FIG. 2;
FIG. 12 is a cross-sectional view illustrating an example of a display panel taken along line II-II' of FIG. 11;
FIG. 13 is a cross-sectional view illustrating an example of a display panel enlarged from an area A4 of FIG. 12; and
FIGS. 14 and 15 are enlarged cross-sectional views illustrating a boundary of a display area and a non-display area of a display device according to other embodiments.

### DETAILED DESCRIPTION

The invention will now be described more fully hereinafter with reference to the accompanying drawings, in which various embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will also be understood that when a layer is referred to as being "on" another layer or substrate, it can be directly on the other layer or substrate, or intervening layers may also be present therebetween. In contrast, when an element is referred to as being "directly on" another element, there are no intervening elements present.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of preferred embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments will be described with reference to the accompanying drawings.

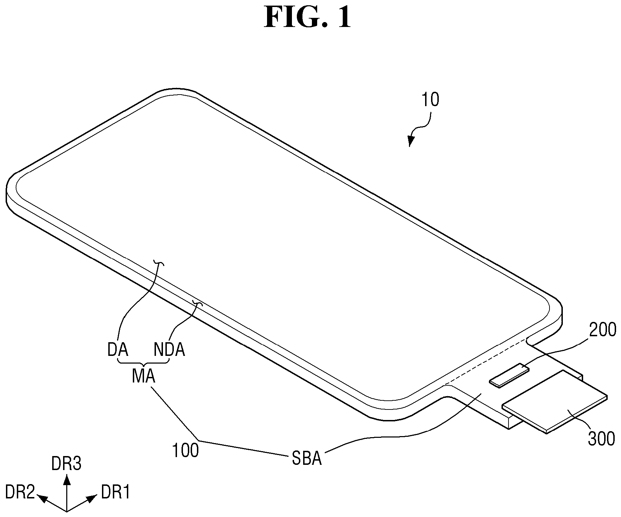

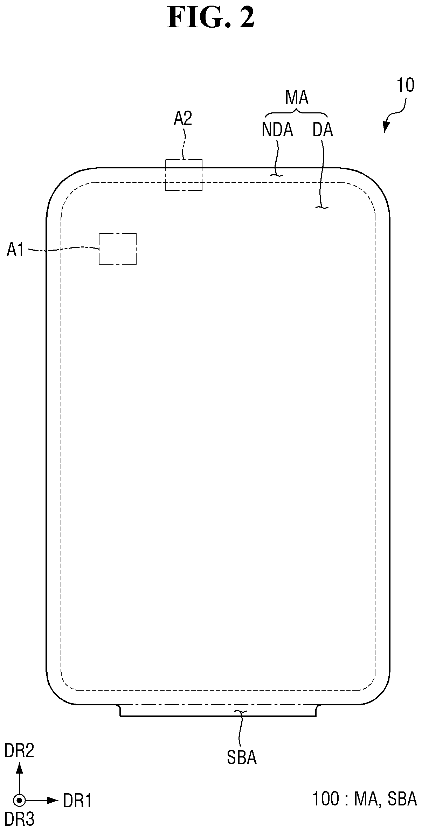

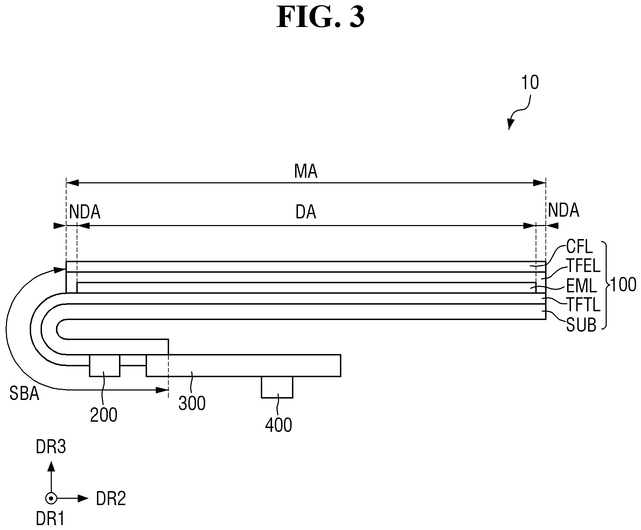

FIG. 1 is a perspective view illustrating a display device according to an embodiment. FIG. 2 is a plan view illustrating the display device of FIG. 1 in a folded state when viewed on a front surface, and FIG. 3 is a cross-sectional view illustrating that the display device of FIG. 1 is folded and viewed on a side.

Referring to FIGS. 1 and 2, a display device 10 according to an embodiment is a device that displays a moving image or a still image and may be used as a display screen of various products such as a television, a laptop computer, a monitor, an advertising board and a device for Internet of things (IoT), for example, as well as portable electronic devices such as a mobile phone, a smart phone, a tablet personal computer (PC), a smart watch, a watch phone, a mobile communication terminal, an electronic diary, an electronic book, a portable multimedia player (PMP), a navigator and an ultra mobile PC (UMPC), for example.

The display device 10 according to an embodiment may be a light emitting display device such as an organic light emitting display device using an organic light emitting diode (organic LED), a quantum dot light emitting display device including a quantum dot light emitting layer, an inorganic light emitting display device including an inorganic semiconductor and a micro (or nano) light emitting display device using a micro (or nano) light emitting diode (micro LED or nano LED). Hereinafter, for convenience of description, embodiments where the display device 10 is an organic light emitting display device will be described, but the disclosure is not limited thereto.

The display device 10 according to an embodiment may include a display panel 100, a display driver 200 and a circuit board 300.

In an embodiment, for example, the display panel 100 may be formed in a rectangular shaped plane having short sides in a first direction DR1 and long sides in a second direction DR2 crossing the first direction DR1, as shown in FIG. 1. A corner where the short side in the first direction DR1 and the long side in the second direction DR2 meet may be formed at a right angle or rounded to have a curvature. The plane shape of the display panel 100 is not limited to the rectangular shape, and may be formed in another polygonal shape, a circular shape or an oval shape.

The display panel 100 may be formed to be flat, but is not limited thereto. In an embodiment, for example, the display panel 100 may include a curved portion formed at left and right ends, having a constant curvature or a variable curvature. In addition, the display panel 100 may be flexibly formed to be curved, bent, folded or rolled.

The display panel 100 may include a main area MA and a sub-area SBA.

The main area MA may include a display area DA for displaying an image and a non-display area NDA not for displaying an image.

The display area DA may occupy most of areas of the display panel 100. The display area DA may be disposed at the center of the display panel 100. Pixels, each of which includes a plurality of light emission areas, may be disposed in the display area DA to display an image. An area A1 shown in FIG. 2 may be a portion of the display area DA.

The non-display area NDA may be disposed to be adjacent to the display area DA. The non-display area NDA may be an outer area of the display area DA, and may be disposed to surround the display area DA. The non-display area NDA may be an edge area of the display panel 100. An area A2 shown in FIG. 2 may be an edge area of the display device 10, and may include a portion of the display area DA and a portion of the non-display area NDA.

The sub-area SBA may extend from one side of the main area MA. The sub-area SBA may include a flexible material capable of being subjected to bending, folding, rolling or the like. In an embodiment, for example, in a state where the sub-area SBA is bent, the sub-area SBA may overlap the main area MA in a thickness direction (a third direction DR3). The sub-area SBA may include a display driver 200, and a pad portion connected to the circuit board 300. In another embodiment, the sub-area SBA may be omitted, and the display driver 200 and the pad portion may be disposed in the non-display area NDA.

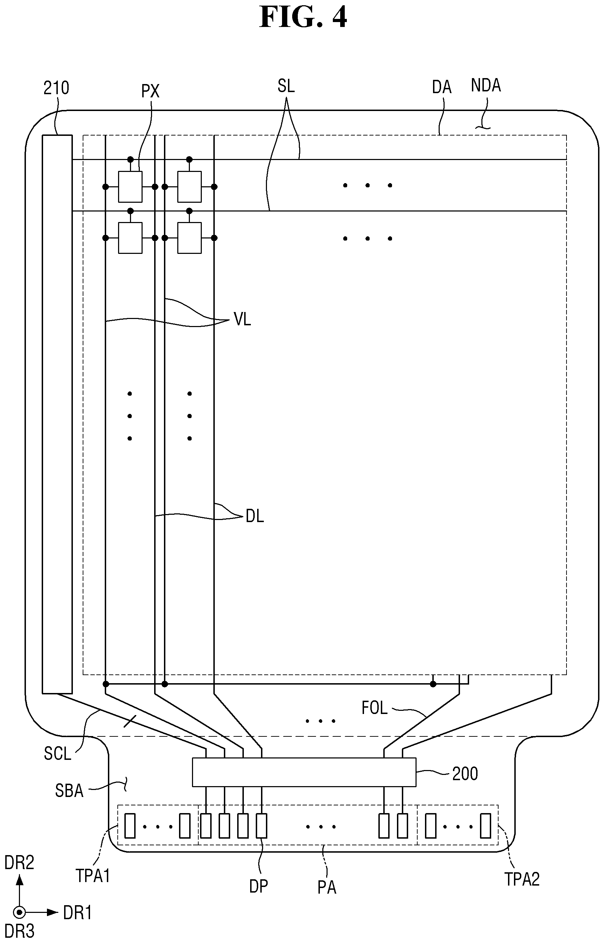

Referring to FIG. 1, the sub-area SBA may include display pads DP (shown in FIG. 4), a display driver 200, and a circuit board 300.

The display pads DP may be disposed at one edge of display panel 100. In an embodiment, for example, the display pads may be disposed at a lower edge of the display panel 100. The display pads DP may be connected to the display driver 200 and the circuit board 300.

The display drivers 200 may generate and output signals and voltages for driving the display panel 100. In an embodiment, the display drivers 200 may generate and output data voltages, power voltages and scan timing signals. The display drivers 200 may supply a power voltage to a power line and supply gate control signals to a gate driver.

The display drivers 200 may be disposed between the display pads DP and the display area DA in the non-display area NDA. The display drivers 200 may be attached to the non-display area NDA of the display panel 100 in a chip on glass (COG) scheme. Alternatively, the display drivers 200 may be attached to the circuit board 300 in a chip on plastic (COP) scheme.

The circuit boards 300 may be disposed at one edge of the display panel 100, and may be disposed on the display pads PD. The circuit boards 300 may be attached to the display pads PD by using a conductive adhesive member such as an anisotropic conductive film and an anisotropic conductive adhesive. Therefore, the circuit boards 300 may be electrically connected to signal lines of the display panel 100. The circuit boards 300 may be flexible printed circuit boards or flexible films such as chip on films.

FIG. 3 is a cross-sectional view illustrating the display device of FIG. 1 in a folded state when viewed on a side.

Referring to FIG. 3, an embodiment of the display panel 100 may include a substrate SUB, a thin film transistor layer TFTL, a light emitting element layer EML, a thin film encapsulation layer TFEL, and a color filter layer CFL.

The substrate SUB may be a base substrate or a base member. The substrate SUB may be a flexible substrate capable of being subjected to bending, folding, rolling or the like. In an embodiment, for example, the substrate SUB may include a polymer resin such as polyimide (PI), but is not limited thereto. In another embodiment, the substrate SUB may include a glass material or a metal material.

The thin film transistor layer TFTL may be disposed on the substrate SUB. The thin film transistor layer TFTL may include a plurality of thin film transistors constituting a pixel circuit of pixels. The thin film transistor layer TFTL may further include scan lines, data lines, power lines, scan control lines, fan-out lines for connecting the display driver 200 with the data lines, and lead lines for connecting the display driver 200 with the pad portion. Each of the thin film transistors may include a semiconductor area, a source electrode, a drain electrode and a gate electrode. In an embodiment, for example, when the scan driver is formed on one side of the non-display area NDA of the display panel 100, the scan driver may include thin film transistors.

The thin film transistor layer TFTL may be disposed in the display area DA, the non-display area NDA and the sub-area SBA. The thin film transistors, the scan lines, the data lines and the power lines of each of the pixels of the thin film transistor layer TFTL may be disposed in the display area DA. The scan control lines and the fan-out lines of the thin film transistor layer TFTL may be disposed in the non-display area NDA. The lead lines of the thin film transistor layer TFTL may be disposed in the sub-area SBA.

The light emitting element layer EML may be disposed on the thin film transistor layer TFTL. The light emitting element layer EML may include a plurality of light emitting elements including a first electrode, a second electrode and a light emitting layer to emit light, and a pixel defining layer for defining pixels. The plurality of light emitting elements of the light emitting element layer EML may be disposed in the display area DA.

In an embodiment, the light emitting element layer EML may be an organic light emitting layer that includes an organic material. The light emitting layer may include a hole transporting layer, an organic light emitting layer and an electron transporting layer. When the first electrode receives a voltage through the thin film transistor of the thin film transistor layer TFTL and the second electrode receives a cathode voltage, holes and electrons may move to the organic light emitting layer through the hole transporting layer and the electron transporting layer, and may be combined with each other in the organic light emitting layer to emit light.

In another embodiment, the light emitting element may include a quantum dot LED including a quantum dot light emitting layer, an inorganic LED including an inorganic semiconductor, or a micro LED.

The thin film encapsulation layer TFEL may cover an upper surface and sides of the light emitting element layer EML, and may protect the light emitting element layer EML. The thin film encapsulation layer TFEL may include at least one inorganic layer and at least one organic layer, to encapsulate the light emitting element layer EML.

The color filter layer CFL may be disposed on the thin film encapsulation layer TFEL. The color filter layer CFL may include a plurality of color filters respectively corresponding to the plurality of light emission areas. Each of the color filters may selectively transmit light of a particular wavelength, and may block or absorb light of another wavelength. The color filter layer CFL may absorb a portion of light incident from the outside of the display device 10 to reduce reflective light due to external light. Therefore, the color filter layer CFL may effectively prevent distortion of a color due to external light reflection from occurring.

In an embodiment, the color filter layer CFL is directly disposed on the thin film encapsulation layer TFEL, such that the display device 10 may not include a separate substrate for the color filter layer CFL. Therefore, a thickness of the display device 10 may be relatively small.

In some embodiments, the display device 10 may further include an optical device (not shown). The optical device may emit or receive light of an infrared, ultraviolet or visible band. In an embodiment, for example, the optical device may be an optical sensor for sensing light incident on the display device 10, such as a proximity sensor, an illuminance sensor, a camera sensor, a fingerprint sensor or an image sensor.

FIG. 4 is a plan view illustrating a display layer of a display device according to an embodiment.

Referring to FIG. 4, in an embodiment, the display layer may include a display area DA and a non-display area NDA.

The display area DA may be disposed at the center of the display panel 100. A plurality of pixels PX, a plurality of scan lines SL, a plurality of data lines DL and a plurality of power lines VL may be disposed in the display area DA. Each of the plurality of pixels PX may be defined as a minimum or basic unit for outputting light.

The plurality of scan lines SL may supply the scan signals received from the scan driver 210 to the plurality of pixels PX. The plurality of scan lines SL may extend in the first direction DR1, and may be spaced apart from each other in the second direction DR2 crossing the first direction DR1.

The plurality of data lines DL may supply the data voltages received from the display driver 200 to the plurality of pixels PX. The plurality of data lines DL may extend in the second direction DR2, and may be spaced apart from each other in the first direction DR1.

The plurality of power lines VL may supply the power voltage received from the display driver 200 to the plurality of pixels PX. In this case, the power voltage may include at least one selected from a driving voltage, an initialization voltage, a reference voltage and a low potential voltage. The plurality of power lines VL may extend in the second direction DR2, and may be spaced apart from each other in the first direction DR1.

The non-display area NDA may surround the display area DA. A scan driver 210, fan-out lines FOL and scan control lines SCL may be disposed in the non-display area NDA. The gate driver 210 may generate a plurality of gate signals based on the scan control signals, and may sequentially supply the plurality of scan signals to the plurality of scan lines SL in accordance with a predetermined order.

The fan-out lines FOL may extend from the display driver 200 to the display area DA. The fan-out lines FOL may supply the data voltages received from the display driver 200 to the plurality of data lines DL.

The scan control line SCL may extend from the display driver 200 to the scan driver 210. The scan control line SCL may supply the scan control signals received from the display driver 200 to the scan driver 210.

The sub-area SBA may include a display driver 200, a pad area PA, and first and second touch pad areas TPA1 and TPA2.

The display driver 200 may output signals and voltages for driving the display panel 100 to the fan-out lines FOL. The display driver 200 may supply the data voltages to the data lines DL through the fan-out lines FOL. The data voltages may be supplied to the plurality of pixels PX, and may control luminance of the plurality of pixels PX. The display driver 200 may supply the scan control signals to the scan driver 210 through the scan control line SCL.

The pad area PA, the first touch pad area TPA1 and the second touch pad area TPA2 may be disposed at an edge of the sub-area SBA. The pad area PA, the first touch pad area TPA1 and the second touch pad area TPA2 may electrically be connected to the circuit board 300 by using a material such as an anisotropic conductive film or a self-assembly anisotropic conductive paste (SAP).

The pad area PA may include a plurality of display pad areas DP. The plurality of display pad areas DP may be connected to a graphic system through the circuit board 300. The plurality of display pad areas DP may be connected to the circuit board 300 to receive digital video data, and may supply the digital video data to the display driver 200.

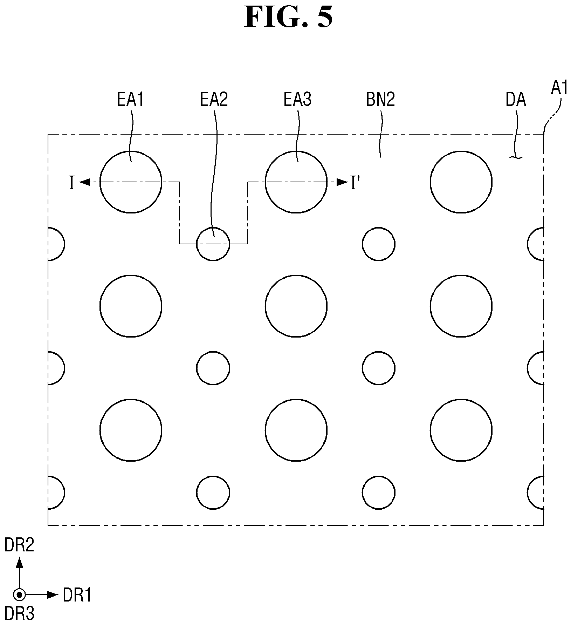

FIG. 5 is a plan view illustrating a portion of a display device according to an embodiment, specifically, an area A1 of FIG. 2. FIG. 5 is a plan view illustrating arrangement of light emission areas EA1, EA2 and EA3 and a second bank layer BN2 in the display area DA of the display device 10.

Referring to FIG. 5, the second bank layer BN2 may expose a portion of the display area DA while covering the display area DA. An opening may be defined or formed in the area exposed without being covered by the second bank layer BN2, and each of the light emission areas EA1, EA2 and EA3 may be defined by the opening.

In FIG. 5, the area exposed without being covered by the second bank layer BN2 is illustrated as a circular shape, but may be a polygonal shape such as a triangle, a rectangle or a hexagon. The plurality of light emission areas EA1, EA2 and EA3 may be disposed in a Pentile^{™} type, for example, a diamond Pentile^{™} type. In an embodiment, for example, the first light emission area EA1 and the third light emission area EA3 may be spaced apart from each other in the first direction DR1, and may be alternately disposed in the first direction DR1 and the second direction DR2. The second light emission area EA2 may be spaced apart from another adjacent second light emission area EA2 in the first direction DR1 and the second direction DR2. The second light emission area EA2, the first light emission area EA1, or the second light emission area EA2 and the third light emission area EA3 may be alternately disposed along any one direction in a plane defined by the first direction DR1 and the second direction DR2. The shape and arrangement of the areas exposed without being covered by the second bank layer BN2 and the plurality of light emission areas are not limited to FIG. 5.

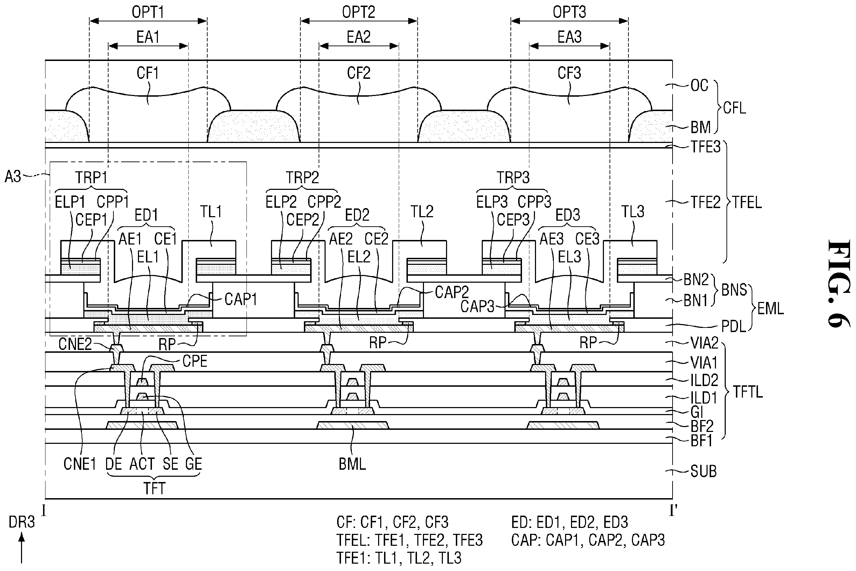

FIG. 6 is a cross-sectional view illustrating a portion of a display area DA of a display panel 100 according to an embodiment. In detail, FIG. 6 is a cross-sectional view taken along line I-I of FIG. 5. FIG. 6 is a cross-sectional view illustrating a substrate SUB, a thin film transistor layer TFTL, a light emitting element layer EML, a thin film encapsulation layer TFEL and a color filter layer CFL.

In an embodiment, the thin film transistor layer TFTL may include a first buffer layer BF1, a lower metal layer BML, a second buffer layer BF2, a thin film transistor TFT, a gate insulating layer GI, a first interlayer insulating layer ILD1, a capacitor electrode CPE, a second interlayer insulating layer ILD2, a first connection electrode CNE1, a first via layer VIA1, a second connection electrode CNE2, and a second via layer VIA2.

In an embodiment, the first buffer layer BF1 may be disposed on the substrate SUB. The first buffer layer BF1 may include an inorganic layer capable of preventing permeation of the air or moisture. In an embodiment, for example, the first buffer layer BF1 may include a plurality of inorganic layers that are alternately stacked.

The lower metal layer BML may be disposed on the first buffer layer BF1. For example, the lower metal layer BML may be formed of a single layer or multi-layer including or made of at least one selected from molybdenum (Mo), aluminium (Al), chromium (Cr), gold (Au), titanium (Ti), nickel (Ni), neodymium (Nd) and copper (Cu) or an alloy thereof.

The second buffer layer BF2 may cover the first buffer layer BF1 and the lower metal layer BML. The second buffer layer BF2 may include an inorganic layer capable of preventing permeation of the air or moisture. In an embodiment, for example, the second buffer layer BF2 may include a plurality of inorganic layers that are alternately stacked.

The thin film transistor TFT may be disposed on the second buffer layer BF2, and may constitute a pixel circuit of each of the plurality of pixels. In an embodiment, for example, the thin film transistor TFT may be a driving transistor or a switching transistor of the pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the lower metal layer BML and the gate electrode GE in the thickness direction DR3, and may be insulated from the gate electrode GE by the gate insulating layer GI. A portion of the semiconductor layer ACT may form the source electrode SE and the drain electrode DE by doping or conductorizing a material of the semiconductor layer ACT.

The gate electrode GE may be disposed on the gate insulating layer GI. The gate electrode GE may overlap the semiconductor layer ACT in the thickness direction DR3 with the gate insulating layer GI interposed therebetween.

The gate insulating layer GI may be disposed on the semiconductor layer ACT. In an embodiment, for example, the gate insulating layer GI may cover the semiconductor layer ACT and the second buffer layer BF2, and may insulate the semiconductor layer ACT from the gate electrode GE. The gate insulating layer GI may be provided with a contact hole through which the first connection electrode CNE1 passes.

The first interlayer insulating layer ILD1 may cover the gate electrode GE and the gate insulating layer GI. The first interlayer insulating layer ILD1 may be provided with a contact hole through which the first connection electrode CNE1 passes. The contact hole of the first interlayer insulating layer ILD1 may be connected to the contact hole of the gate insulating layer GI and the contact hole of the second interlayer insulating layer ILD2.

The capacitor electrode CPE may be disposed on the first interlayer insulating layer ILD1. The capacitor electrode CPE may overlap the gate electrode GE in the thickness direction DR3. The capacitor electrode CPE and the gate electrode GE may form a capacitance.

The second interlayer insulating layer ILD2 may cover the capacitor electrode CPE and the first interlayer insulating layer ILD1. The second interlayer insulating layer ILD2 may be provided with a contact hole through which the first connection electrode CNE1 passes. The contact hole of the second interlayer insulating layer ILD2 may be connected to the contact hole of the first interlayer insulating layer ILD 1 and the contact hole of the gate insulating layer GI.

The first connection electrode CNE1 may be arranged on the second interlayer insulating layer ILD2. The first connection electrode CNE1 may electrically connect the drain electrode DE of the thin film transistor TFT with the second connection electrode CNE2. The first connection electrode CNE1 may be inserted into the contact hole defined or formed in the second interlayer insulating layer ILD2, the first interlayer insulating layer ILD1 and the gate insulating layer GI to contact the drain electrode DE of the thin film transistor TFT.

The first via layer VIA1 may cover the first connection electrode CNE1 and the second interlayer insulating layer ILD2. The first via layer VIA1 may protect the thin film transistor TFT. The first via layer VIA1 may be provided with a contact hole through which the second connection electrode CNE2 passes.

The second connection electrode CNE2 may be disposed on the first via layer VIA1. The second connection electrode CNE2 may electrically connect the first connection electrode CNE1 with pixel electrode AE1, AE2 and AE3 of the light emitting element ED. The second connection electrode CNE2 may be inserted into the contact hole formed in the first via layer VIA1 to contact the first connection electrode CNE1.

The second via layer VIA2 may cover the second connection electrode CNE2 and the first via layer VIA1. The second via layer VIA2 may include a contact hole through which the pixel electrodes AE1, AE2 and AE3 of the light emitting element ED pass.

The light emitting element layer EML may be disposed on the thin film transistor layer TFTL. The light emitting element layer EML may include a light emitting element ED, a pixel defining layer PDL, a capping layer CAP and a bank structure BNS. The light emitting element ED may include pixel electrodes AE1, AE2 and AE3, light emitting layers EL1, EL2 and EL3, and common electrodes CE1, CE2 and CE3.

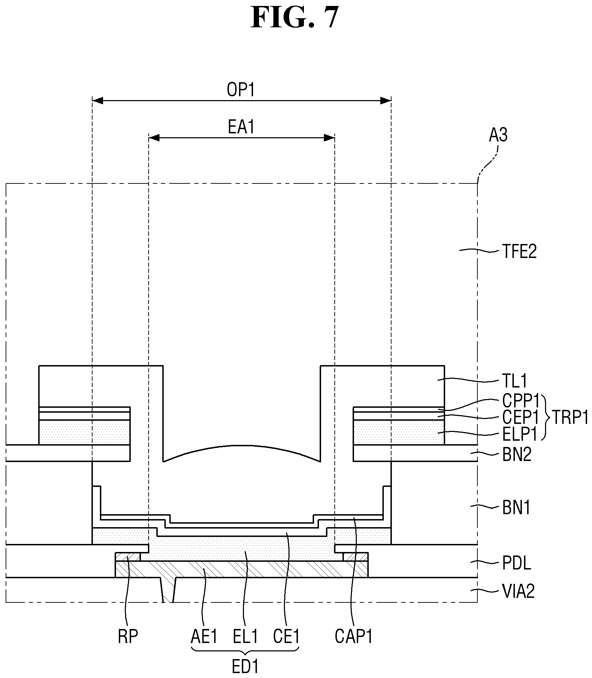

FIG. 7 is an enlarged plan view illustrating a first light emission area of FIG. 6, specifically an area A3 of FIG. 6.

Referring to FIG. 7 in addition to FIG. 6, an embodiment of the display device 10 may include a plurality of light emission areas EA1, EA2 and EA3 disposed or defined in the display area DA. The light emission areas EA1, EA2 and EA3 may include areas in which light is emitted from the light emitting elements ED1, ED2 and ED3 to pass through the color filter layer CFL in the third direction DR3, where the pixel electrodes AE1, AE2 and AE3, the light emitting layers EL1, EL2 and EL3 and the common electrodes CE1, CE2 and CE3 are sequentially stacked in the light emitting elements ED1, ED2 and ED3. The light emission areas EA1, EA2 and EA3 may include a first light emission area EA1, a second light emission area EA2 and a third light emission area EA3, which are spaced apart from one another and emit light of a same color or different colors.

In an embodiment, areas or sizes of the first to third light emission areas EA1, EA2 and EA3 may be the same as one another. In an embodiment, for example, in the display device 10, the first light emission area EA1, the second light emission area EA2 and the third light emission area EA3 may have the same size, but are not limited thereto. In the display device 10, the first to third light emission areas EA1, EA2 and EA3 may have different sizes from each other. In an embodiment, for example, the size of the second light emission area EA2 may be larger than that of each of the first light emission area EA1 and the third light emission area EA3, and the size of the third light emission area EA3 may be larger than that of the first light emission area EA1. The intensity of light emitted from the corresponding light emission areas EA1, EA2 and EA3 may be varied depending on the sizes of the light emission areas EA1, EA2 and EA3, and the sizes of the light emission areas EA1, EA2 and EA3 may be adjusted so that a color of a screen displayed on the display device 10 may be controlled. In an embodiment of FIG. 6, the sizes of the light emission areas EA1, EA2 and EA3 are illustrated as being the same as one another, but are not limited thereto.

In an embodiment of the display device 10, one first light emission area EA1, one second light emission area EA2 and one third light emission area EA3, which are disposed to be adjacent to one another, may form one pixel group. One pixel group may include the light emission areas EA1, EA2 and EA3 that emit light of different colors, thereby representing a white grayscale, but the disclosure is not limited thereto. A combination of the light emission areas EA1, EA2 and EA3 constituting one pixel group may be variously modified depending on the arrangement of the light emission areas EA1, EA2 and EA3 and the colors of the light emitted from the light emission areas EA1, EA2 and EA3.

A plurality of openings OP1, OP2 and OP3 formed in the bank structure BNS of the light emitting element layer EML may be defined along a boundary of a first bank layer BN1. The first bank layer BN1 and a second bank layer BN2 of the bank structure BNS may surround the light emission areas EA1, EA2 and EA3. Each of the openings OP1, OP2 and OP3 may correspond to one of the first to third light emission areas EA1, EA2 and EA3.

The display device 10 may include a plurality of light emitting elements ED1, ED2 and ED3 respectively disposed in different light emission areas EA1, EA2 and EA3. The light emitting elements ED1, ED2 and ED3 may include a first light emitting element ED1 disposed in the first light emission area EA1, a second light emitting element ED2 disposed in the second light emission area EA2, and a third light emitting element ED3 disposed in the third light emission area EA3.

The light emitting elements ED1, ED2 and ED3 may include pixel electrodes AE1, AE2 and AE3, light emitting layers EL1, EL2 and EL3 and common electrodes CE1, CE2 and CE3, respectively, and the light emitting elements ED1, ED2 and ED3 respectively disposed in the different light emission areas EA1, EA2 and EA3 may emit light of different colors depending on materials of the light emitting layers EL1, EL2 and EL3. In an embodiment, for example, the first light emitting element ED1 disposed in the first light emission area EA1 may emit first light of a red color, which has a peak wavelength in a range of 610 nanometers (nm) to 650 nm, the second light emitting element ED2 disposed in the second light emission area EA2 may emit second light of a green color, which has a peak wavelength in a range of 510 nm to 550 nm, and the third light emitting element ED3 disposed in the third light emission area EA3 may emit third light of a blue color, which has a peak wavelength in a range of 440 nm to 480 nm. The first to third light emission areas EA1, EA2 and EA3 constituting one pixel may include the light emitting elements ED1, ED2 and ED3 for emitting light of different colors to represent a white grayscale. Alternatively, as the light emitting layers EL1, EL2 and EL3 may include two or more materials for emitting light of different colors, one light emitting layer may emit mixture light. In an embodiment, for example, the light emitting layers EL1, EL2 and EL3 may include a material for emitting red light and a material for emitting green light together to emit yellow light, or may include all of a material for emitting red light, a material for emitting green light and a material for emitting blue light to emit white light.

The pixel electrodes AE1, AE2 and AE3 may be disposed on the second via layer VIA2. The pixel electrodes AE1, AE2 and AE3 may be disposed in the plurality of light emission areas EA1, EA2 and EA3, respectively. The pixel electrodes AE1, AE2 and AE3 may include a first pixel electrode AE1 disposed in the first light emission area EA1, a second pixel electrode AE2 disposed in the second light emission area EA2, and a third pixel electrode AE3 disposed in the third light emission area EA3. The first pixel electrode AE1, the second pixel electrode AE2 and the third pixel electrode AE3 may be respectively spaced apart from one another on the second via layer VIA2,

The pixel electrodes AE1, AE2 and AE3 may be electrically connected to the drain electrode DE of the thin film transistor TFT through the first and second connection electrodes CNE1 and CNE2. Edges of the spaced pixel electrodes AE1, AE2 and AE3 may be covered by the pixel defining layer PDL, so that the first to third pixel electrodes AE1, AE2 and AE3 may be insulated from one another. Each of the pixel electrodes AE1, AE2 and AE3 overlap one of the openings OP1, OP2 and OP3.

The pixel electrodes AE1, AE2 and AE3 may include a transparent electrode material and/or a conductive metal material. The conductive metal material may include at least one selected from silver (Ag), copper (Cu), aluminium (Al), nickel (Ni), lanthanum (La), titanium (Ti) and titanium nitride (TiN). The transparent electrode material may include at least one selected from indium tin oxide (ITO), indium zinc oxide (IZO) and indium tin zinc oxide (ITZO). The pixel electrodes AE1, AE2 and AE3 may have a multi-layered structure of a transparent electrode material and a conductive metal material.

The pixel defining layer PDL may be disposed on the second via layer VIA2, a residual pattern RP and the pixel electrodes AE1, AE2 and AE3. The pixel defining layer PDL may be entirely disposed on the second via layer VIA2, and may cover sides of the pixel electrodes AE1, AE2 and AE3 and the residual pattern RP to expose a portion of upper surfaces of the pixel electrodes AE1, AE2 and AE3. In an embodiment, for example, the pixel defining layer PDL may expose the first pixel electrode AE1 in the first light emission area EA1, and the first light emitting layer EL1 may be disposed directly on the first pixel electrode AE1.

The pixel defining layer PDL may include an inorganic insulating material. The pixel defining layer PDL may include at least one selected from a silicon nitride layer, a silicon oxynitride layer, a silicon oxide layer, a titanium oxide layer, an aluminium oxide layer, a tantalum oxide layer, a hafnium oxide layer, a zinc oxide layer and an amorphous silicon layer, but is not limited thereto.

According to an embodiment, the pixel defining layer PDL is disposed on the pixel electrodes AE1, AE2 and AE3, and may be spaced apart from the upper surfaces of the pixel electrodes AE1, AE2 and AE3. The pixel defining layer PDL may not directly contact the upper surfaces of the pixel electrodes AE1, AE2 and AE3 while partially overlapping the upper surfaces of the pixel electrodes AE1, AE2 and AE3 in the thickness direction DR3 of the substrate SUB, and the residual pattern RP may be disposed between the pixel defining layer PDL and the pixel electrodes AE1, AE2 and AE3. However, the pixel defining layer PDL may directly contact the sides of the pixel electrode AE1, AE2 and AE3. Sides of the pixel defining layer PDL may be more protruded toward the light emission areas EA1, EA2 and EA3 than sides of the second bank layer BN2.

The residual pattern RP may be disposed on the edge of each of the pixel electrodes AE1, AE2 and AE3. The pixel defining layer PDL may not directly contact the upper surfaces of the pixel electrodes AE1, AE2 and AE3 due to the residual pattern RP. In a manufacturing process of the display device 10, a portion of a sacrificial layer disposed on the pixel electrodes AE1, AE2 and AE3 may be removed so that the residual pattern RP may be formed. The residual pattern RP may include a metal or an oxide semiconductor material. In the drawing, sides of the residual pattern RP, which are directed toward the light emission areas EA1, EA2 and EA3, are only illustrated as being more recessed than the sides of the pixel defining layer PDL, but the disclosure is not limited thereto. The sides of the residual pattern RP may be more protruded than the sides of the pixel defining layer PDL toward the light emission areas EA1, EA2 and EA3, or may be aligned with the sides of the pixel defining layer PDL.

The light emitting layers EL1, EL2 and EL3 may be disposed on the pixel electrodes AE1, AE2 and AE3. The light emitting layers EL1, EL2 and EL3 may be organic light emitting layers including or made of an organic material, and may be formed on the pixel electrodes AE1, AE2 and AE3 through a deposition process. The light emitting layers EL1, EL2 and EL3 may have a multi-layered structure, and each of a hole injection material, a hole transporting material, a light emitting material, an electron transporting material and/or an electron injection material may constitute a layer. When the thin film transistor TFT applies a predetermined voltage to the pixel electrodes AE1, AE2 and AE3 of the light emitting elements ED1, ED2 and ED3 and the common electrodes CE1, CE2 and CE3 of the light emitting elements ED1, ED2 and ED3 receive a common voltage or a cathode voltage, holes and electrons may be injected and transported, and may be combined with each other in the light emitting layers EL1, EL2 and EL3 to emit light.

The light emitting layers EL1, EL2 and EL3 may include a first light emitting layer EL1, a second light emitting layer EL2 and a third light emitting layer EL3, which are disposed in the different light emission areas EA1, EA2 and EA3, respectively. The first light emitting layer EL1 may be disposed on the first pixel electrode AE1 in the first light emission area EA1, the second light emitting layer EL2 may be disposed on the second pixel electrode AE2 in the second light emission area EA2, and the third light emitting layer EL3 may be disposed on the third pixel electrode AE3 in the third light emission area EA3. The plurality of light emitting layers EL1, EL2 and EL3 may emit light of different colors, respectively, or one of the light emitting layers EL1, EL2 and EL3 may emit mixture light. In an embodiment, the first light emitting layer EL1 may emit red light, the second light emitting layer EL2 may emit green light, and the third light emitting layer EL3 may emit blue light. In another embodiment, the first light emitting layer EL1 may emit yellow light, which is mixture light of red light and green light, and the second light emitting layer EL2 may emit blue light. In another embodiment, the first light emitting layer EL1 may emit white light, which is mixture light of red light, green light and blue light.

The light emitting layers EL1, EL2 and EL3 may be disposed on an upper surface of the pixel defining layer PDL. In an embodiment, the light emitting layers EL1, EL2 and EL3 may be disposed in spaces between the pixel electrodes AE1, AE2 and AE3 and the pixel defining layer PDL. In an embodiment, the light emitting layers EL1, EL2 and EL3 may be in contact with the pixel defining layer PDL, the residual pattern RP and the pixel electrodes AE1, AE2 and AE3.

The common electrodes CE1, CE2 and CE3 may be disposed on the light emitting layers EL1, EL2 and EL3. The common electrodes CE1, CE2 and CE3 may include a transparent conductive material so that light generated from the light emitting layers EL1, EL2 and EL3 may be emitted. The common electrodes CE1, CE2 and CE3 may receive a common voltage or a low potential voltage. When the pixel electrodes AE1, AE2 and AE3 receive a voltage corresponding to the data voltage and the common electrodes CE1, CE2 and CE3 receive a low potential voltage, a potential difference may be formed between the pixel electrodes AE1, AE2 and AE3 and the common electrodes CE1, CE2 and CE3, whereby the light emitting layers EL1, EL2 and EL3 may emit light.

The common electrodes CE1, CE2 and CE3 may include a first common electrode CE1, a second common electrode CE2 and a third common electrode CE3, which are disposed in the different light emission areas EA1, EA2 and EA3, respectively. The first common electrode CE1 may be disposed on the first light emitting layer EL1 in the first light emission area EA1, the second common electrode CE2 may be disposed on the second light emitting layer EL2 in the second light emission area EA2, and the third common electrode CE3 may be disposed on the third light emitting layer EL3 in the third light emission area EA3. The first to third common electrodes CE1, CE2 and CE3 may be spaced apart from one another. One end and the other end of each of the first to third common electrodes CE1, CE2 and CE3 may overlap the openings OP1, OP2 and OP3.

Capping layers CAP1, CAP2 and CAP3 may be disposed on the common electrodes CE1, CE2 and CE3. The capping layers CAP1, CAP2 and CAP3 may include an organic material or an inorganic insulating material to cover patterns disposed on the light emitting elements ED1, ED2 and ED3. The capping layers CAP1, CAP2 and CAP3 may prevent the light emitting elements ED1, ED2 and ED3 from being damaged from the external air. In an embodiment, the capping layers CAP1, CAP2 and CAP3 may include an organic material such as a-NPD, NPB, TPD, m-MTDATA, Alq₃, LiF and/or CuPc or an inorganic material such as aluminium oxide, titanium oxide, tantalum oxide, hafnium oxide, zinc oxide, silicon oxide, silicon nitride and/or silicon oxynitride.

The capping layers CAP1, CAP2 and CAP3 may include a first capping layer CAP1, a second capping layer CAP2 and a third capping layer CAP3, which are disposed in the different light emission areas EA1, EA2, EA3, respectively. The first to third capping layers CAP1, CAP2 and CAP3 may be spaced apart from one another.

The display device 10 may include a plurality of bank structures BNS disposed on the pixel defining layer PDL. The bank structure BNS may have a structure in which the bank layers BN1 and BN2 including their respective materials different from each other are sequentially stacked, may include a plurality of openings OP1, OP2 and OP3 including light emission areas EA1, EA2 and EA3, and may be disposed to overlap a light blocking layer BM that will be described later. The light emitting elements ED1, ED2 and ED3 of the display device 10 may be disposed to overlap the openings of the bank structure BNS.

The bank structure BNS may include a first bank layer BN1 and a second bank layer BN2, which are sequentially stacked on the pixel defining layer PDL.

The first bank layer BN1 may be disposed on the pixel defining layer PDL. Sides of the first bank layer BN1 may be more recessed than those of the pixel defining layer PDL in an opposite direction of a direction directed toward the light emission areas EA1, EA2 and EA3. The sides of the first bank layer BN1 may be more recessed than those of the second bank layer BN2, which will be described later, in the opposite direction of the direction directed toward the light emission areas EA1, EA2 and EA3.

According to an embodiment, the first bank layer BN1 may include a metal material. In an embodiment, the first bank layer BN1 may include aluminium (Al) or an alloy of aluminium (Al).

According to an embodiment, the common electrode CE1, CE2 and CE3 may be directly in contact with the sides of the first bank layer BN1. The common electrodes CE1, CE2 and CE3 of the different light emitting elements ED1, ED2 and ED3 may be directly in contact with the first bank layer BN1, and the first bank layer BN1 may include a metal material so that the common electrodes CE1, CE2 and CE3 may be electrically connected to one another through the first bank layer BN1.

The light emitting layers EL1, EL2 and EL3 may be directly in contact with the sides of the first bank layer BN1. An area in which the common electrodes CE1, CE2 and CE3 are in contact with the sides of the first bank layer BN1 may be greater than an area in which the light emitting layers EL1, EL2 and EL3 are in contact with the sides of the first bank layer BN1. The common electrodes CE1, CE2 and CE3 may be disposed on the sides of the first bank layer BN1 to reach an area larger than the light emitting layers EL1, EL2 and EL3 or a higher position on the sides of the first bank layer BN1. Since the common electrodes CE1, CE2 and CE3 of the different light emitting elements ED1, ED2 and ED3 are electrically connected to one another through the first bank layer BN1, it may be desired that the common electrodes CE1, CE2 and CE3 are to be in contact with the first bank layer BN1 in more areas.

The second bank layer BN2 may be disposed on the first bank layer BN1. The second bank layer BN2 may include a tip that is an area more protruded than the first bank layer BN1. The sides of the second bank layer BN2 may be more protruded toward the light emission areas EA1, EA2 and EA3 than the sides of the first bank layer BN1.

As the sides of the second bank layer BN2 have a shape more protruded toward the light emission areas EA1, EA2 and EA3 than the sides of the first bank layer BN1, an undercut structure of the first bank layer BN1 may be formed below the tip of the second bank layer BN2.

In the display device 10 according to an embodiment, the bank structure BNS may include a tip protruded toward the light emission areas EA1, EA2 and EA3 so that the light emitting layers EL1, EL2 and EL3 and the common electrodes CE1, CE2 and CE3, which are spaced apart from each other, may be formed by deposition and etching processes rather than a mask process. In an embodiment, for example, although the light emitting layers EL1, EL2 and EL3 of the light emitting elements ED1, ED2 and ED3 and the common electrodes CE1, CE2 and CE3 are formed by the deposition process without using a mask, deposited materials may be disconnected with the bank structure BNS interposed therebetween by the tip of the second bank layer BN2 without being connected among the light emission areas EA1, EA2 and EA3. After a material for forming a specific layer is formed on an entire surface of the display device 10, different layers may be individually formed in the different light emission areas EA1, EA2 and EA3 through a process of removing a layer formed in an undesired area through etching. In an embodiment of the display device 10, the different light emitting elements ED1, ED2 and ED3 may be respectively formed for the light emission areas EA1, EA2 and EA3 through deposition and etching processes without using a mask process, elements provided for a mask process in the display device 10 may be omitted, and a size of the non-display area NDA may be minimized. In an embodiment, for example, a spacer provided for the mask process may be omitted.

A side shape of the bank structure BNS may have a structure formed due to a difference in etch rates in an etching process as the first bank layer BN1 and the second bank layer BN2 include their respective materials different from each other. According to an embodiment, the second bank layer BN2 may include a material having an etch rate slower than that of the first bank layer BN1, and the first bank layer BN1 may be further etched during the etching process so that a lower surface of the tip of the second bank layer BN2 may be exposed and an undercut may be formed below the second bank layer BN2. In an embodiment, the first bank layer BN1 may include aluminium (Al) or an alloy of aluminium (Al), and the second bank layer BN2 may include titanium (Ti) or an alloy of titanium (Ti).

The tip of the second bank layer BN2 may overlap the common electrodes CE1, CE2 and CE3, the light emitting layers EL1, EL2 and EL3 or the pixel defining layer PDL in the direction DR3 perpendicular to the substrate SUB. The common electrodes CE1, CE2 and CE3 may be formed below the lower surface of the tip of the second bank layer BN2. One end and the other end of each of the common electrodes CE1, CE2 and CE3 may overlap the second bank layer BN2 in the thickness direction DR3 of the substrate. A maximum vertical distance from the substrate SUB to the common electrodes CE1, CE2 and CE3 may be shorter than a maximum vertical distance from the substrate SUB to the second bank layer BN2.

The display device 10 may include trace patterns TRP1, TRP2 and TRP3, which become traces of the deposition process, on the bank structure BNS. The trace patterns TRP1, TRP2 and TRP3 may include organic patterns ELP1, ELP2 and ELP3, electrode patterns CEP1, CEP2 and CEP3 and capping patterns CPP1, CPP2 and CPP3, and may surround outer edges of the light emission areas EA1, EA2 and EA3 on the second bank layer BN2.

The trace patterns TRP1, TRP2 and TRP3 may be traces formed as the bank structure BNS is disconnected from the light emitting layers EL1, EL2 and EL3 in the light emission areas EA1, EA2 and EA3, the common electrodes CE1, CE2 and CE3 and the capping layers CAP1, CAP2 and CAP3 by the tip included in the bank structure BNS. The light emitting layers EL1, EL2 and EL3, the common electrodes CE1, CE2 and CE3 and the capping layers CAP1, CAP2 and CAP3 may be formed in the openings, the organic patterns ELP1, ELP2 and ELP3 may be disconnected from the light emitting layers EL1, EL2 and EL3 by the tip of the bank structures BNS. The electrode patterns CEP1, CEP2 and CEP3 may be disconnected from the common electrodes CE1, CE2 and CE3 by the tip of the bank structures BNS. Likewise, the capping patterns CPP1, CPP2 and CPP3 may be disconnected from the capping layers CAP1, CAP2 and CAP3 by the tip of the bank structure BNS. The trace patterns TRP1, TRP2 and TRP3 may be formed by patterning near each of the light emission areas EA1, EA2 and EA3.

The display device 10 may include a plurality of organic patterns ELP1, ELP2 and ELP3 including a same material as that of the light emitting layers EL1, EL2 and EL3, disposed on the bank structure BNS. The first organic pattern ELP1 may include a same material as that of the first light emitting layer EL1 of the first light emitting element ED1. The second organic pattern ELP2 may include a same material as that of the second light emitting layer EL2 of the second light emitting element ED2, and the third organic pattern ELP3 may include a same material as that of the third light emitting layer EL3 of the third light emitting element ED3. Each of the organic patterns ELP1, ELP2 and ELP3 may be formed in the process of forming the light emitting layers EL1, EL2 and EL3 including the same material. The organic patterns ELP1, ELP2 and ELP3 may be disposed to be adjacent to the light emission areas EA1, EA2 and EA3 in which the light emitting layers EL1, EL2 and EL3 are respectively disposed.

The display device 10 according to an embodiment may include a plurality of electrode patterns CEP1, CEP2 and CEP3 including a same material as that of the common electrodes CE1, CE2 and CE3 disposed on the bank structure BNS. The first electrode pattern CEP1, the second electrode pattern CEP2 and the third electrode pattern CEP3 may be disposed directly on the first organic pattern ELP1, the second organic pattern ELP2 and the third organic pattern ELP3, respectively. The arrangement relationship of the electrode patterns CEP1, CEP2 and CEP3 and the organic patterns ELP1, ELP2 and ELP3 may be the same as the arrangement relationship of the light emitting layers EL1, EL2 and EL3 of the light emitting elements ED1, ED2 and ED3 and the common electrodes CE1, CE2 and CE3.

The display device 10 may include capping patterns CPP1, CPP2 and CPP3 disposed above the bank structure BNS. The capping patterns CPP1, CPP2 and CPP3 may be disposed directly on the first electrode pattern CEP1, the second electrode pattern CEP2 and the third electrode pattern CEP3, respectively. The arrangement relationship of the capping patterns CPP1, CPP2 and CPP3 and the electrode patterns CEP1, CEP2 and CEP3 may be the same as the arrangement relationship of the common electrodes CE1, CE2 and CE3 and the capping layers CAP1, CAP2 and CAP3.

The thin film encapsulation layer TFEL may be disposed on the light emitting elements ED1, ED2 and ED3 and the bank structure BNS, and may cover the plurality of light emitting elements ED1, ED2 and ED3 and the bank structure BNS. Also, the thin film encapsulation layer TFEL may be disposed in the non-display area NDA as well as the display area DA. The thin film encapsulation layer TFEL may include at least one inorganic film to prevent oxygen or moisture from being permeated into the light emitting element layer EML. The thin film encapsulation layer TFEL may include at least one organic film to protect the light emitting element layer EML from particles such as dust.

In an embodiment, the thin film encapsulation layer TFEL may include a first inorganic encapsulation layer TFE1, an organic encapsulation layer TFE2 and a second inorganic encapsulation layer TFE3, which are sequentially stacked.

Each of the first inorganic encapsulation layer TFE1 and the second inorganic encapsulation layer TFE3 may include one or more inorganic insulation materials. The inorganic insulating material may include at least one selected from silicon oxide, silicon nitride and silicon oxynitride, and may be, for example, aluminium oxide, titanium oxide, tantalum oxide, hafnium oxide, zinc oxide, silicon oxide, silicon nitride and/or silicon oxynitride. Each of the first inorganic encapsulation layer TFE1 and the second inorganic encapsulation layer TFE3 may be a single layer or may have a multi-layered structure in which two or more of the aforementioned inorganic materials are stacked.

The organic encapsulation layer TFE2 may include a polymer-based material. The polymer-based material may include an acrylic resin, an epoxy-based resin, polyimide or polyethylene. In an embodiment, for example, the organic encapsulation layer TFE2 may include an acrylic resin, for example, polymethyl methacrylate, polyacrylic acid, etc. The organic encapsulation layer TFE2 may be formed by hardening a monomer or coating a polymer.

The first inorganic encapsulation layer TFE1 may include a first inorganic layer disposed in the display area DA, and the first inorganic layer may be disposed on the light emitting elements ED1, ED2 and ED3 and the bank structure BNS. The first inorganic layer TFE1 may include a plurality of sub-inorganic layers TL1, TL2 and TL3 disposed to respectively correspond to the different light emission areas EA1, EA2 and EA3. The sub-inorganic layers TL1, TL2 and TL3 may include an inorganic insulating material to cover the light emitting elements ED1, ED2 and ED3. The first sub-inorganic layer TL1, the second sub-inorganic layer TL2 and the third sub-inorganic layer TL3 may prevent the light emitting elements ED1, ED2 and ED3 from being damaged from the external air.

The first inorganic encapsulation layers TFE1 may be formed through a chemical vapor deposition (CVD) method, and thus may be formed along a step difference of the deposited layers. In an embodiment, for example, the first sub-inorganic layer TL1, the second sub-inorganic layer TL2 and the third sub-inorganic layer TL3 may form a thin film even under the tip of the bank structure BNS. The sub-inorganic layers TL1, TL2 and TL3 may be disposed along an upper surface, sides and a lower surface of the second bank layer BN2, the sides of the first bank layer BN1 and upper surfaces of the common electrodes CE1, CE2 and CE3. The first sub-inorganic layer TL1, the second sub-inorganic layer TL2 and the third sub-inorganic layer TL3 may be in contact with the lower surface of the second bank layer BN2 to prevent moisture permeation from the external air from occurring.

The first sub-inorganic layer TL1 does not overlap the second light emission area EA2 and the third light emission area EA3, and may be disposed only on the first light emission area EA1 and the bank structure BNS near the first light emission area EA1. The second sub-inorganic layer TL2 does not overlap the first light emission area EA1 and the third light emission area EA3, and may be disposed only on the second light emission area EA2 and the bank structure BNS near the second light emission area EA2. The third sub-inorganic layer TL3 does not overlap the first light emission area EA1 and the second light emission area EA2, and may be disposed only on the third light emission area EA3 and the bank structure BNS near the third light emission area EA3.

The first sub-inorganic layer TL1 may be formed after the first common electrode CE1 is formed, the second sub-inorganic layer TL2 may be formed after the second common electrode CE2 is formed, and the third sub-inorganic layer TL3 may be formed after the third common electrode CE3 is formed. The first sub-inorganic layer TL1, the second sub-inorganic layer TL2 and the third sub-inorganic layer TL3 may be disposed to be spaced apart from one another on the bank structure BNS. The first sub-inorganic layer TL1, the second sub-inorganic layer TL2 and the third sub-inorganic layer TL3 may include the same material or different materials.

The organic encapsulation layer TFE2 is disposed on the second bank layer BN2 and the first inorganic encapsulation layer TFE1. A portion of the organic encapsulation layer TFE2 may be in contact with the second bank layer BN2 between the spaced sub-inorganic layers of the first inorganic layer of the first inorganic encapsulation layer TFE1.

The second inorganic encapsulation layer TFE3 may be disposed on the organic encapsulation layer TFE2. The second inorganic encapsulation layer TFE3 may include aluminium oxide, titanium oxide, tantalum oxide, hafnium oxide, zinc oxide, silicon oxide, silicon nitride and/or silicon oxynitride.

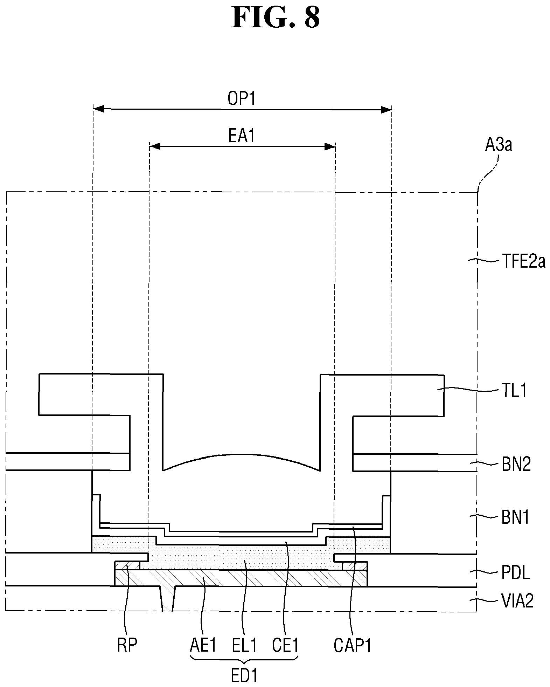

FIGS. 8 to 10 are enlarged cross-sectional views illustrating a first light emission area of a display device according to other embodiments.

The area A3a of the display device shown in FIG. 8 is substantially the same as the area A3 of the display device shown in FIG. 7 except that there are no trace patterns TRP1, TRP2 and TRP3 on the second bank layer BN2. In an embodiment, as shown in FIG. 8, after the first sub-inorganic layer TL1 is formed on the first light emission area EA1, the trace pattern TRP1 between the first sub-inorganic layer TL1 and the second bank layer BN2 may be removed through an etching process. An organic encapsulation layer TFE2a may be disposed in a space between the first sub-inorganic layer TL1 and the second bank layer BN2.

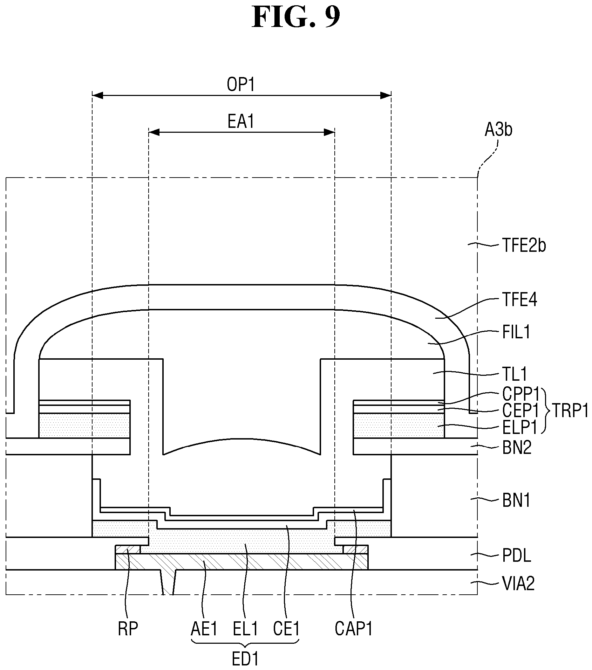

The area A3b of the display device shown in FIG. 9 is substantially the same as the area A3 of the display device shown in FIG. 7 except that a third inorganic encapsulation layer TFE4 is disposed between the first sub-inorganic layer TL1 and the organic encapsulation layer TFE2 and a first filling material FIL1 is disposed between the first sub-inorganic layer TL1 and the third inorganic encapsulation layer TFE4. In an embodiment, as shown in FIG. 9, the third inorganic encapsulation layer TFE4 may prevent the light emitting elements ED1, ED2 and ED3 from being damaged due to permeation of particles such as an etchant between the spaced sub-inorganic layers TL1, TL2 and TL3 of the first inorganic encapsulation layer TFE1. The third inorganic encapsulation layer TFE4 may be disposed on the entire surface of the substrate SUB. The third inorganic encapsulation layer TFE4 may include an inorganic material such as the first inorganic encapsulation layer TFE1 or the second inorganic encapsulation layer TFE3.

Filling materials FIL1, FIL2 and FIL3 may be disposed between the sub-inorganic layers TL1, TL2 and TL3 on the light emitting elements ED1, ED2 and ED3 and the third inorganic encapsulation layer TFE4. The filling materials FIL1, FIL2 and FIL3 may be sealed by the sub-inorganic layers TL1, TL2 and TL3 of the first inorganic encapsulation layer TFE1 and the third inorganic encapsulation layer TFE4. The first to third filling materials FIL1, FIL2 and FIL3 may respectively correspond to the first to third light emission areas EA1, EA2 and EA3, and may be spaced apart from each other. The filling materials FIL1, FIL2 and FIL3 may include an organic material, and the organic material may be a photoresist used in a photo process.

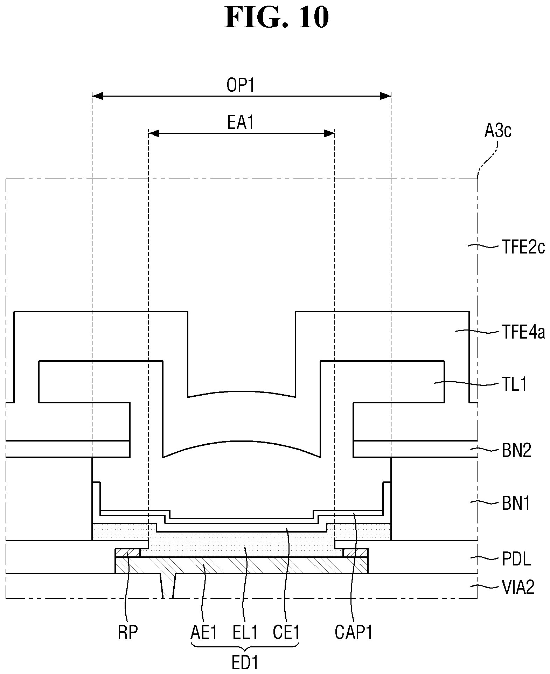

The area A3c of the display device shown in FIG. 10 is substantially the same as the area A3 of the display device shown in FIG. 7 except that there are no trace patterns TRP1, TRP2 and TRP3 on the second bank layer BN2 and a third inorganic encapsulation layer TFE4a is disposed between the first sub-inorganic layer TL1 and the organic encapsulation layer TFE2. In an embodiment, as described with reference to FIG. 9, the third inorganic encapsulation layer TFE4a may prevent the light emitting elements ED1, ED2 and ED3 from being damaged, and may include an inorganic material. In an embodiment, the third inorganic encapsulation layer TFE4a may be disposed in a space between the first sub-inorganic layer TL1 and the second bank layer BN2, and may be disposed on the entire surface of the substrate SUB.

Referring back to FIG. 6, the light blocking layer BM may be disposed on the thin film encapsulation layer TFEL. The light blocking layer BM may include a plurality of holes OPT1, OPT2 and OPT3 disposed to overlap the light emission areas EA1, EA2 and EA3. In an embodiment, for example, the first hole OPT1 may be disposed to overlap the first light emission area EA1. The second hole OPT2 may be disposed to overlap the second light emission area EA2, and the third hole OPT3 may be disposed to overlap the third light emission area EA3. An area or size of each of the holes OPT1 to OPT3 may be larger than that of each of the emission areas EA1, EA2 and EA3. Since the holes OPT1, OPT2 and OPT3 of the light-blocking layer BM are formed to be greater than the emission areas EA1, EA2 and EA3, the light emitted from the light emission areas EA1, EA2 and EA3 may be visible to the user as well as the front surface of the display device 10.

The light blocking layer BM may include a light-absorbing material. In an embodiment, for example, the light blocking layer BM may include an inorganic black pigment or an organic black pigment. The inorganic black pigment may be carbon black, and the organic black pigment may include at least one selected from lactam black, perylene black and aniline black, but is not limited thereto. The light blocking layer BM may prevent visible light from being permeated among the first to third light emission areas EA1, EA2 and EA3, thereby improving a color reproduction rate of the display device 10.

The display device 10 may include a plurality of color filters CF1, CF2 and CF3 disposed on the light emission areas EA1, EA2 and EA3. The plurality of color filters CF1, CF2 and CF3 may be respectively disposed to correspond to the light emission areas EA1, EA2 and EA3. In an embodiment, for example, the color filters CF1, CF2 and CF3 may be disposed on the light blocking layer BM that includes the plurality of holes OPT1, OPT2 and OPT3 disposed to correspond to the light emission areas EA1, EA2 and EA3. The holes of the light blocking layer may be formed to overlap the light emission areas EA1, EA2 and EA3 or the openings of the bank structure BNS, and may form a light output area from which the light emitted from the light emission areas EA1, EA2 and EA3 is output. Each of the color filters CF1, CF2 and CF3 may have an area larger than that of the light blocking layer BM, and each of the color filters CF1, CF2 and CF3 may completely cover the light output area formed by the holes.

The color filters CF1, CF2 and CF3 may include a first color filter CF1, a second color filter CF2 and a third color filter CF3, which are disposed to correspond to the different light emission areas EA1, EA2 and EA3, respectively. The color filters CF1, CF2 and CF3 may include a colorant such as a dye or pigment for absorbing light of another wavelength band other than light of a specific wavelength band, and may be disposed to correspond to colors of the light emitted from the light emission areas EA1, EA2 and EA3. In an embodiment, for example, the first color filter CF1 may be a red color filter disposed to overlap the first light emission area EA1, where the red color filter transmits only first light of a red color. The second color filter CF2 may be a green color filter disposed to overlap the second light emission area EA2, where the green color filter transmits only second light of a green color. The third color filter CF3 may be a blue color filter disposed to overlap the third light emission area EA3, where the blue color filter transmits only third light of a blue color.

The plurality of color filters CF1, CF2 and CF3 may be spaced apart from other adjacent color filters CF1, CF2 and CF3 on the light blocking layer BM. Each of the color filters CF1, CF2 and CF3 covers the holes OPT1, OPT2 and OPT3 of the light blocking layer BM and has an area larger than that of the hole. Each of the color filters CF1, CF2 and CF3 may have an area that is spaced apart from other color filters CF1, CF2 and CF3 on the light blocking layer BM, but the disclosure is not limited thereto. The plurality of color filters CF1, CF2 and CF3 may be disposed to partially overlap other adjacent color filters CF1, CF2 and CF3. The different color filters CF1, CF2 and CF3 are areas that do not overlap the light emission areas EA1, EA2 and EA3, and may overlap each other on the light blocking layer BM that will be described later. The display device 10 may reduce the intensity of reflective light due to external light as the color filters CF1, CF2 and CF3 overlap one another. Furthermore, the display device 10 may control a color sense of the reflective light due to external light by adjusting a layout, a shape, an area and the like of the color filters CF1, CF2 and CF3 on the plan view.

An overcoat layer OC may be disposed on the color filters CF1, CF2 and CF3 to planarize upper ends of the color filters CF1, CF2 and CF3. The overcoat layer OC may be a colorless light-transmissive layer having no color of a visible light band. In an embodiment, for example, the overcoat layer OC may include a colorless light-transmissive organic material such as an acrylic resin.

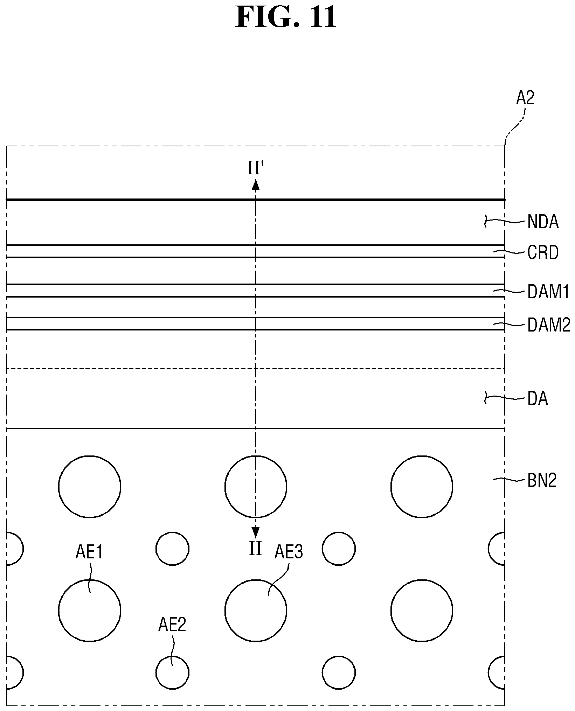

The non-display area NDA1 will be described in detail with reference to FIGS. 11 to 13.

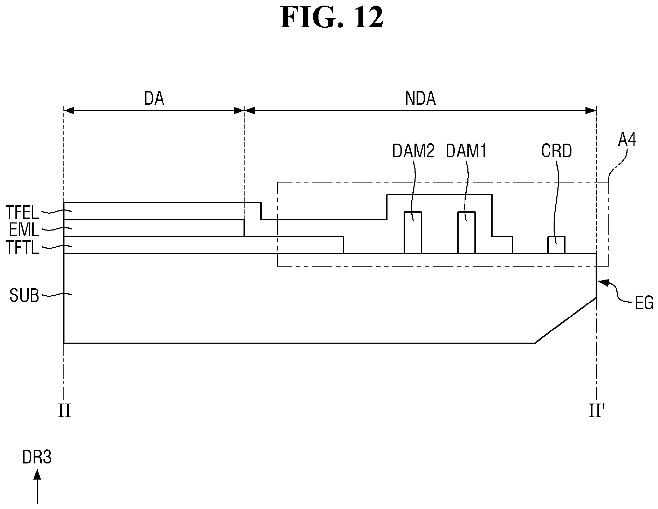

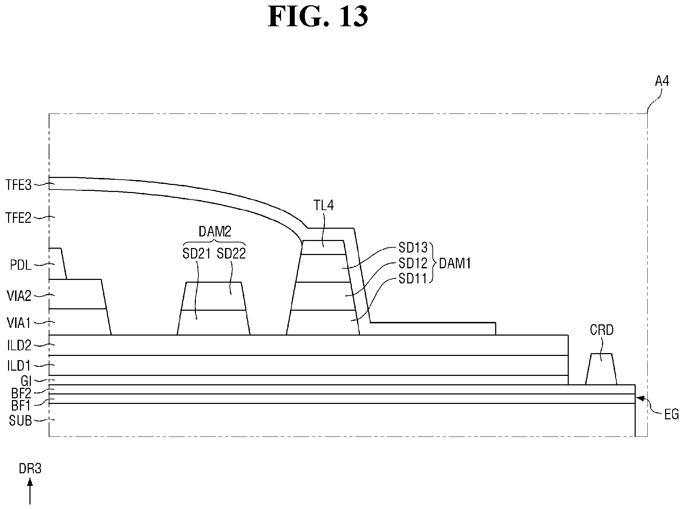

FIG. 11 is an enlarged view illustrating an edge area of the display device 10, which is a boundary of the display area DA and the non-display area NDA1 of the display device. FIG. 11 is an enlarged plan view illustrating an area A2 of FIG. 2, and FIG. 12 is a cross-sectional view illustrating an example of a display device taken along line II-II' of FIG. 11. FIG. 13 is an enlarged cross-sectional view illustrating an area A4 of FIG. 12.

Referring to FIGS. 11 to 13, in an embodiment of the display device 10, the light emitting element ED may be disposed in the light emission areas EA1, EA2 and EA3 of the display area DA, and the non-display area NDA may be disposed near the display area DA. A second dam DAM2 surrounding the display area DA may be disposed in the non-display area NDA, a first dam DAM1 surrounding the outside of the second dam DAM2 may be disposed, and a crack dam CRD may be disposed outside the first dam DAM1.

In an embodiment, as shown in FIG. 12, the thin film encapsulation layer TFTL may overlap the light emitting element layer EML, the second dam DAM2 and the first dam DAM1 in a thickness direction DR3 of the substrate SUB. Although not shown in the drawings, in another embodiment, the thin film encapsulation layer TFTL may also overlap the crack dam CRD.

The first dam DAM1 may be formed to prevent the organic material from overflowing into the display area DA during a manufacturing process thereof. In an embodiment, as shown in FIG. 13, the organic encapsulation layer TFE2 may not flow up to an edge EG due to the first dam DAM1 in the non-display area NDA.

The first dam DAM1 may overlap the non-display area NDA, and may be positioned to surround the display area. The first dam DAM1 may be disposed between the second interlayer insulating layer ILD2 and the second inorganic encapsulation layer TFE3.

The first dam DAM1 may include a first sub-dam SD11 disposed on the second interlayer insulating layer ILD2 and a second sub-dam SD12 disposed on the first sub-dam SD11. In an embodiment, the first dam DAM1 may further include a third sub-dam SD13 disposed on the second sub-dam SD12. In an embodiment, the third sub-dam SD12 may be omitted. The first sub-dam SD11 may include a same material as that of a corresponding one of the first via layer VIA1, the second via layer VIA2 and the pixel defining layer PDL. The second sub-dam SD12 may include a same material as that of a corresponding one of the first via layer VIA1, the second via layer VIA2 and the pixel defining layer PDL. The third sub-dam SD13 may include a same material as that of a corresponding one of the first via layer VIA1, the second via layer VIA2 and the pixel defining layer PDL. In an embodiment, for example, the first sub-dam SD11 may include a same material as that of the first via layer VIA1, the second sub-dam SD12 may include a same material as that of the second via layer VIA2, and the third sub-dam SD13 may include a same material as that of the pixel defining layer PDL.

The second dam DAM2 may be positioned at an inner side relative to the first dam DAM1 and thus positioned between the first dam DAM1 and the light emitting elements ED1, ED2 and ED3. The second dam DAM2 may include a first sub-dam SD21 disposed on the second interlayer insulating layer ILD2, and a second sub-dam SD22 disposed on the first sub-dam SD21. The first sub-dam SD21 may include a same material as that of a corresponding one of the first via layer VIA1, the second via layer VIA2 and the pixel defining layer PDL. The second sub-dam SD22 may include a same material as that of a corresponding one of the first via layer VIA1, the second via layer VIA2 and the pixel defining layer PDL. In an embodiment, for example, the first sub-dam SD21 may include a same material as that of the first via layer VIA1 or the second via layer VIA2, and the second sub-dam SD22 may include a same material as that of the pixel defining layer PDL. A total thickness of the second dam DAM2 may be the same as or different from that of the first dam DAM1.

The first inorganic encapsulation layer TFE1 may include a first inorganic layer disposed in the display area and a second inorganic layer disposed in the non-display area. The first inorganic layer and the second inorganic layer may be spaced apart from each other. The second inorganic layer may be formed of a single or a plurality of sub-inorganic layers disposed on the first dam DAM1 and/or the second dam DAM2.

Referring to FIG. 13, the second inorganic layer of the first inorganic encapsulation layer TFE1 may include a fourth sub-inorganic layer TL4, and the fourth sub-inorganic layer TL4 may be disposed on the first dam DAM1. The fourth sub-inorganic layer TL4 may be disposed between the first dam DAM1 and the second inorganic encapsulation layer TFE3. The fourth sub-inorganic layer TL4 may be simultaneously formed when one of the first to third sub-inorganic layers TL1, TL2 and TL3 of the display area DA is formed. That is, the fourth sub-inorganic layer TL4 may include a same material as that of one of the first to third sub-inorganic layers TL1, TL2 and TL3, and may be spaced apart from the first to third sub-inorganic layers TL1, TL2 and TL3.

The first dam DAM1 may include a first side directed toward the display area DA and a second side opposite to the first side. The first side of the first dam DAM1 may have an area that does not overlap the fourth sub-inorganic layer TL4 of the first inorganic encapsulation layer TFE1 in the thickness direction DR3 of the substrate SUB. In a case where the first inorganic encapsulation layer TFE1 (TL4) spaced apart from the display area DA and the second dam DAM2 is disposed on the first dam DAM1, the filling amount of the organic encapsulation layer TFE2 may be more increased than a case where the first inorganic encapsulation layer TFE1 is formed on the entire surface of the substrate SUB, and the organic encapsulation film TFE2 may be more effectively prevented from overflowing.

The first side of the first dam DAM1 may overlap the organic encapsulation layer TFE2 in the thickness direction DR3 of the substrate SUB. In an embodiment, the first side of the first dam DAM1 may be in contact with the organic encapsulation layer TFE2. The second side of the first dam DAM1 may not overlap the organic encapsulation layer TFE2 in the thickness direction DR3 of the substrate SUB. In an embodiment, the second side of the first dam DAM1 may be in contact with the second inorganic encapsulation layer TFE3. The first side and the second side of the first sub-dam SD11 of the first dam DAM1 may not overlap the first inorganic encapsulation layer TFE1.

The second dam DAM2 may include a first side directed toward the display area DA and a second side opposite to the first side. The first side and the second side of the second dam DAM2 may overlap the organic encapsulation layer TFE2 in the thickness direction DR3 of the substrate SUB. In an embodiment, the first side and the second side of the second dam DAM2 may be in contact with the organic encapsulation layer TFE2.

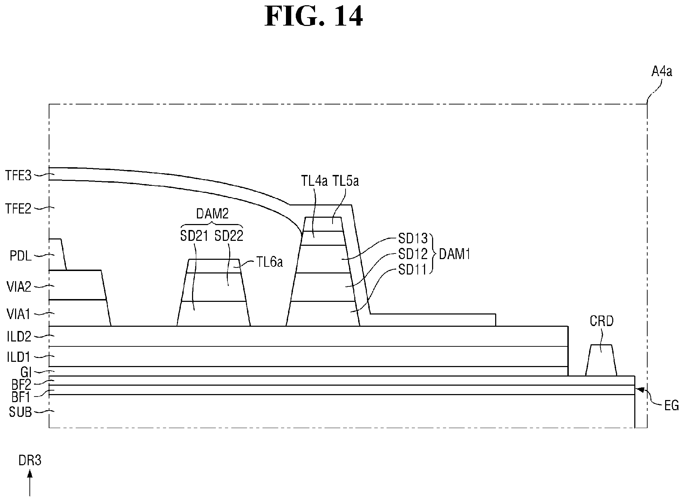

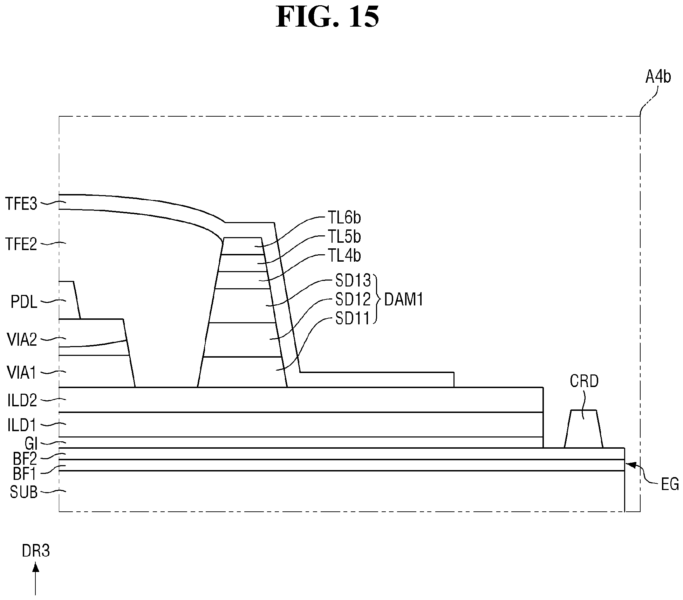

The second inorganic layer of the first inorganic encapsulation layer TFE1 may include a plurality of sub-inorganic layers (e.g., sub-inorganic layers TL4a, TL5a and TL6a in FIG. 14 or sub-inorganic layers TL4b, TL5b and TL6b in FIG. 15). Thicknesses of the sub-inorganic layers TL4, TL5 and TL6 may be the same as or different from one another. In an embodiment, the plurality of sub-inorganic layers may be sequentially stacked on the first dam DAM1. In another embodiment, the sub-inorganic layers may be disposed in the first dam DAM1 and the second dam DAM2, respectively, and may be spaced apart from each other.

FIGS. 14 and 15 are enlarged cross-sectional views illustrating a boundary of a display area and a non-display area of a display device according to other embodiments.

Referring to FIG. 14, in an embodiment, the second inorganic layer of the first inorganic encapsulation layer TFE1 may include a fourth sub-inorganic layer TL4a and a fifth sub-inorganic layer TL5a, which are disposed on the first dam DAM1, and a sixth sub-inorganic layer TL6a disposed on the second dam DAM2. The number of sub-inorganic layers disposed on the first dam DAM1 may be different from the number of sub-inorganic layers disposed on the second dam DAM2. The fourth sub-inorganic layer TL4a and the sixth sub-inorganic layer TL6a may be spaced apart from each other.

The fifth sub-inorganic layer TL5a may be disposed on the fourth sub-inorganic layer TL4a. Each of the fourth sub-inorganic layer TL4a and the fifth sub-inorganic layer TL5a may include a same material as that of a corresponding one of the first to third sub-inorganic layers TL1, TL2 and TL3 of the display area DA. In an embodiment, for example, the fourth sub-inorganic layer TL4a may include a same material as that of the first sub-inorganic layer TL1, and the fifth sub-inorganic layer TL5a may include a same material as that of the second sub-inorganic layer TL2. The sixth sub-inorganic layer TL6a may include a same material as that of any one of the first to third sub-inorganic layers TL1, TL2 and TL3.

The first side and the second side of the second dam DAM2 may have an area that does not overlap the sixth sub-inorganic layer TL6a in the thickness direction DR3 of the substrate SUB. The first side and the second side of the first sub-dam SD21 of the second dam DAM2 may not overlap the sixth sub-inorganic layer TL6a.

The embodiment shown in FIG. 15 is substantially the same as the embodiment shown in FIG. 13 except that the second dam DAM2 is omitted and three-layered sub-inorganic layers TL4b, TL5b and TL6b are sequentially stacked on the first dam DAM1. The number and the total thickness of first inorganic encapsulation layers TFE1 disposed on the dam may be increased, and at the same time, the non-display area NDA may be reduced.

In an embodiment, as shown in FIG. 15, the sub-inorganic layers TL4b, TL5b and TL6b sequentially stacked on the first dam DAM1 may include a same material as that of a corresponding one of the first to third sub-inorganic layers TL1, TL2 and TL3 of the display area DA, respectively. In an embodiment, for example, the fourth sub-inorganic layer TL4b may include a same material as that of the first sub-inorganic layer TL1, the fifth sub-inorganic layer TL5b may include a same material as that of the second sub-inorganic layer TL2, and the sixth sub-inorganic layer TL6b may include a same material as that of the third sub-inorganic layer TL3.

The crack dam CRD may be disposed outside the first dam DAM1. The crack dam CRD may be disposed to be close to the edge EG of the display panel 100. The crack dam CRD may be a structure for preventing cracks of inorganic films of an encapsulation layer ENC from being propagated in a process of cutting the substrate SUB during a manufacturing process of the display device 10. The crack dam CRD may be disposed along the left, upper and right edges of the display panel 100. The crack dam CRD may not be disposed at the lower edge of the display panel 100. The crack dam CRD may be an outermost structure disposed at the outermost portion of the left, upper and right sides of the display panel 100.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device comprising:
a substrate on which a display area and a non-display area disposed near the display area are defined;
a first bank layer disposed on the substrate, wherein the bank layer defines a plurality of openings in the display area;
a second bank layer disposed on the first bank layer, wherein the second bank layer comprises a side more protruded than a side of the first bank layer;
a plurality of light emitting elements disposed on the substrate and overlapping the openings;
a first inorganic encapsulation layer disposed on the light emitting elements;
an organic encapsulation layer disposed on the first inorganic encapsulation layer and the second bank layer;
a second inorganic encapsulation layer disposed on the organic encapsulation layer; and
a first dam disposed between the substrate and the second inorganic encapsulation layer in the non-display area,
wherein an area of a first side of the first dam does not overlap the first inorganic encapsulation layer in a thickness direction of the substrate.

2. The display device of claim 1, wherein the first side of the first dam is directed toward the display area, and
the organic encapsulation layer overlaps the first side of the first dam in the thickness direction of the substrate.

3. The display device of claim 1 or claim 2, wherein the first side of the first dam is in contact with the organic encapsulation layer, and
a second side of the first dam, which is opposite to the first side thereof, is in contact with the second inorganic encapsulation layer.

4. The display device of any one of claims 1 to 3, wherein the first inorganic encapsulation layer comprises a first inorganic layer disposed on the light emitting elements and a second inorganic layer disposed on the first dam and spaced apart from the first inorganic layer.

5. The display device of claim 4, wherein the first inorganic layer comprises a plurality of sub-inorganic layers disposed on each of the light emitting elements, and
the sub-inorganic layers of the first inorganic layer are spaced apart from each other, optionally wherein the second inorganic layer comprises a same material as a material of a corresponding one of the sub-inorganic layers of the first inorganic layer.

6. The display device of claims 4 or claim 5, wherein the second inorganic layer comprises a plurality of sub-inorganic layers sequentially stacked on the first dam.

7. The display device of any one of claims 4 to 6, further comprising:
a second dam between the first dam and the light emitting elements.

8. The display device of claim 7, wherein the second inorganic layer comprises a first sub-inorganic layer disposed on the first dam and a second sub-inorganic layer disposed on the second dam, and
the first sub-inorganic layer and the second sub-inorganic layer are spaced apart from each other, optionally wherein the second inorganic layer further comprises a third sub-inorganic layer disposed on the first sub-inorganic layer.

9. The display device of any one of claims 1 to 8, wherein each of the light emitting elements comprises
a pixel electrode disposed on the substrate and overlapping the openings;
a light emitting layer disposed on the pixel electrode; and
a common electrode disposed on the light emitting layer, and
one end of the common electrode and another end of the common electrode, which is opposite to the one end thereof, overlap the openings.

10. The display device of claim 9, wherein:
(i) the common electrode is in contact with the first bank layer; and/or
(ii) the first inorganic encapsulation layer comprises a plurality of sub-inorganic layers disposed on the light emitting element overlapping the openings and the second bank layer near the openings.

11. The display device of any one of claims 1 to 10, further comprising:
a third inorganic encapsulation layer disposed between the first inorganic encapsulation layer and the organic encapsulation layer.

12. A display device comprising:
a substrate on which a display area and a non-display area disposed near the display area are defined;
a first bank layer disposed on the substrate, wherein the first bank layer defines a plurality of openings in the display area;
a second bank layer disposed on the first bank layer, wherein the second bank layer comprises a side more protruded than a side of the first bank layer;
a first light emitting element disposed on the substrate and overlapping a first opening of the openings;
a second light emitting element disposed on the substrate and overlapping a second opening of the openings, which is spaced apart from the first opening;
a first dam disposed on the substrate in the non-display area;
a first inorganic encapsulation layer comprising a first sub-inorganic layer disposed on the first light emitting element, a second sub-inorganic layer disposed on the second light emitting element and a third sub-inorganic layer disposed on the first dam;
an organic encapsulation layer disposed on the first inorganic encapsulation layer; and
a second inorganic encapsulation layer disposed on the organic encapsulation layer,
wherein the first sub-inorganic layer, the second sub-inorganic layer and the third sub-inorganic layer of the first inorganic encapsulation layer are spaced apart from one another.

13. The display device of claim 12, wherein:
(i) the first sub-inorganic layer and the second sub-inorganic layer are in contact with a lower surface of the second bank layer; and/or
(ii) a first side of the first dam is in contact with the organic encapsulation layer, and
a second side of the first dam, which is opposite to the first side thereof, is in contact with the second inorganic encapsulation layer.

14. A display device comprising:
a substrate on which a display area and a non-display area disposed near the display area are defined;
a plurality of light emitting elements disposed on the substrate in the display area;
a first dam disposed on the substrate in the non-display area;
a second dam disposed on the substrate in the non-display area and positioned between the light emitting elements and the first dam;
a first inorganic encapsulation layer comprising a first sub-inorganic layer disposed on the first dam, a second sub-inorganic layer disposed on the first sub-inorganic layer and a third sub-inorganic layer disposed on the second dam;
an organic encapsulation layer disposed on the light emitting elements and the third sub-inorganic layer; and
a second inorganic encapsulation layer disposed on the organic encapsulation layer and the first dam,
wherein the first sub-inorganic layer and the third sub-inorganic layer are spaced apart from each other.

15. The display device of claim 14, wherein:
(i) the first inorganic encapsulation layer comprises a fourth sub-inorganic layer disposed on a first light emitting element of the light emitting elements, and a fifth sub-inorganic layer disposed on a second light emitting element and spaced apart from the fourth sub-inorganic layer,
the first sub-inorganic layer comprises a same material as a material of the fourth sub-inorganic layer, and
the second sub-inorganic layer comprises a same material as a material of the fifth sub-inorganic layer; and/or
(ii) a first side of the first dam overlaps the organic encapsulation layer,
a second side of the first dam, which is opposite to the first side thereof, does not overlap the organic encapsulation layer, and
a first side of the second dam and a second side of the second dam, which is opposite to the first side thereof, overlap the organic encapsulation layer.
